# EUROPEAN PATENT APPLICATION

(11) **EP 1 283 569 A2**
(43) Date of publication of application: **12.02.2003**
(21) Application number: 02011167.0
(22) Date of filing: 21.05.2002
(51) Int. Cl.: H01S 5/068, H01S 5/0683

(54) **Laser diode control apparatus**

(30) Priority: 13.06.2001 JP 2001178809
(71) Applicant: MOTOROLA, INC., Schaumburg, IL 60196 (US); FUJITSU LIMITED, Kawasaki-shi, Kanagawa 211 (JP)
(72) Inventor: Sakamoto, Hiroshi, Tokyo 106-8573 (JP); Masuda, Shinji, Tokyo 168-0072 (JP); Kanesaka, Hiroki, Kawasaki-shi, Kanagawa 211-8588 (JP); Matsuyama, Toru, Sapporoshi, Hokkaido 060-0807 (JP); Miki, Makoto, Sapporoshi, Hokkaido 060-0807 (JP)
(74) Representative: Gibson, Sarah Jane

(57) **Abstract**

A control circuit capable of accommodating individual characteristics and aging of laser diodes is provided. A laser diode control apparatus for controlling the light-emission output of a laser diode in accordance with temperature data, includes a driver circuit (12), connected to the laser diode, for supplying a drive current to the laser diode; a memory (18) capable of pre-storing respective drive current values appropriate under a plurality of temperature conditions for individual laser diodes; and a central processing unit (14), coupled to the memory, for controlling, via the driver circuit, the laser diode in accordance with the temperature data and the appropriate drive current value from the memory.

## Description

### Field of the Invention

The present invention relates generally to a laser diode control apparatus, and more specifically to a laser diode control apparatus that gives consideration to temperature characteristics of individual laser diodes.

### Background of the Invention

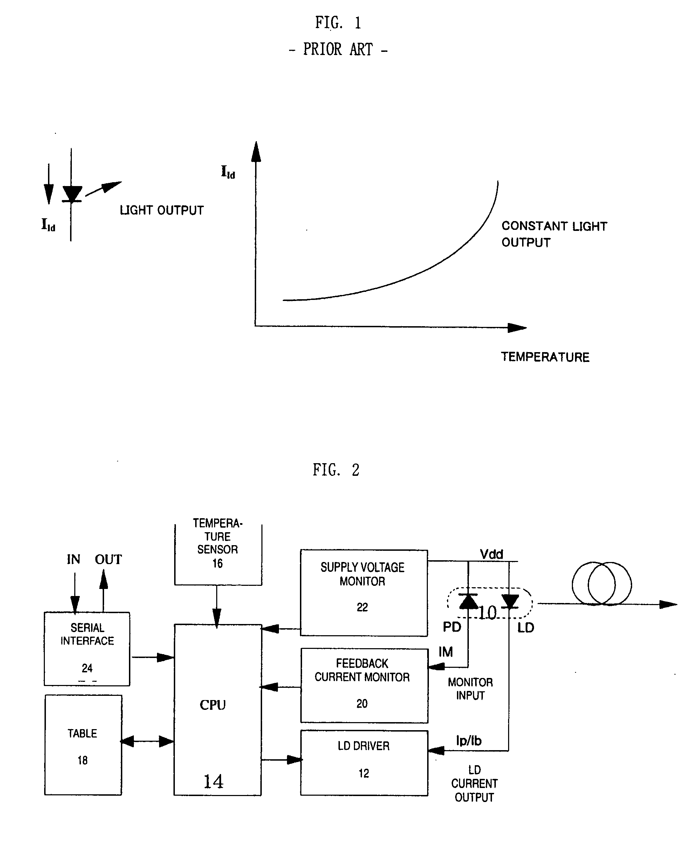

Laser diodes are usually used to achieve optical transmission of laser light used for data communication in switches, such as telephone switches, for example. For laser-based communication, optical signals that comply with standards, such as OC1, OC3, and OC12, are required. Levels of laser light are required to remain constant for a long period of time. Light levels that are either too strong or too weak do not satisfy its desired objective. Laser diodes have very poor temperature characteristics, as is well known in the art, and suffer substantial changes in emission efficiency as the temperature varies. As shown in Fig. 1, the laser diode typically suffers degraded emission efficiency as the temperature rises; as such, it is necessary to increase the drive current, Id, of the laser diode accordingly. To attain a certain level of light output within an actual range of operating temperatures, it is necessary to change the drive current by about one order of magnitude. Conventionally, in order to achieve a certain level of light output, a laser diode driving apparatus is equipped with an analog circuit and an external adjustment circuit, and a thermistor is used to detect the temperature of the diode, thereby controlling the drive current in an analog manner.

However, because the temperature of the laser diode and the drive current required to attain a certain level of light output do not have a linear relationship, it is difficult to approximate them with a simple function and thus to design a control circuit that implements accurate control. Additionally, because the thermistor that detects temperature also suffers variations in temperature characteristics, only a combination where temperature characteristics of a thermistor and temperature characteristics of a laser diode to be controlled are well matched can be used. There are significant manufacturing variances for laser diodes, and an attempt to sort out diodes with well-matched characteristics results in poor yield and considerably high manufacturing cost.

Furthermore, laser diodes suffer aging, so that, with prior art control circuits, it is very difficult to achieve control with accurate consideration given to aging of the laser diode.

Accordingly, it is an object of the present invention to provide a control circuit capable of accommodating individual characteristics and aging of laser diodes. Especially, a laser diode control circuit is equipped with a storage means, such as a flash memory, to which individual characteristics of laser diodes are written, so that laser diodes with a wider range of characteristics can be used.

### Brief Description of the Drawings

Fig. 1 is a graph depicting temperature characteristics of a laser diode.
Fig. 2 is a block diagram of a control circuit according to one embodiment of the present invention.
Fig. 3 depicts, in tabular form, the data stored in a table according to one embodiment of the present invention.
Fig. 4 is a graph for explaining feed-forward control according to one embodiment of the present invention.
Fig. 5 is a graph for explaining feedback control according to one embodiment of the present invention.

### Detailed Description of the Invention

An embodiment of the present invention is described below with reference to the drawings. Fig. 2 is a block diagram of a laser diode control circuit according to one embodiment of the present invention. A laser diode module 10 includes a laser diode, LD, and a photo diode, PD. A supply voltage Vdd is provided to the laser diode module 10 (laser diode LD and photo diode PD). The laser diode module 10 is driven by a driver circuit, or a LD driver 12, and is controlled by bias current, Ib, and pulse current, Ip. The bias current Ib is a current value immediately before light emission starts as the current provided to the laser diode LD is increased from zero. The pulse current Ip is a current used to distinguish between high and low of digital data to be transmitted.

The LD driver 12 is controlled by a central processing unit (CPU) 14. The CPU 14 receives temperature data from a temperature sensor 16, data on the supply voltage Vdd from a supply voltage monitor 22, and current data from a table 18 to control the LD driver 12 based thereon. The temperature sensor 16 may utilize the Vbe voltage of a parasitic bipolar transistor that may be formed on an on-chip CMOS substrate, for example. In that case, a voltage change relative to temperature is approximately -2mV/°C. When the supply voltage Vdd changes, the LD diode current can be controlled so as to compensate for that change. The light output emitted from the laser diode LD is monitored by the photo diode PD, and the monitor output is sent to the CPU 14 via a feedback current monitor circuit 20 for further processing.

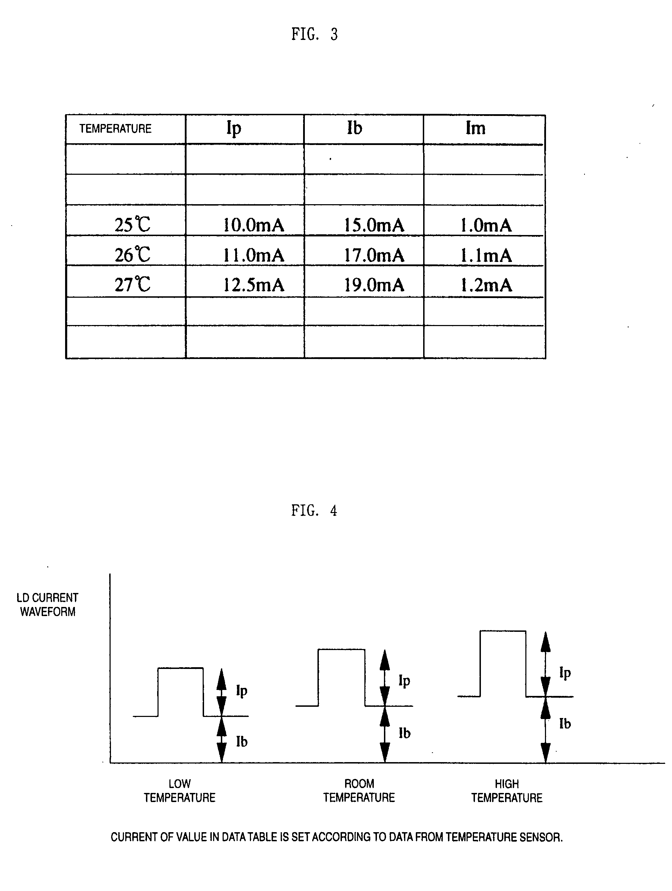

A nonvolatile memory or programmable memory may be used for the table 18, where data specific to each laser diode can be written. Such memories include, for instance, a flash memory, EPROM, and EEPROM. The table 18 stores data as shown in Fig. 3. The laser diode LD is activated, and the resulting information, such as temperature and monitor current value, is processed, so that bias current values and pulse current values that are optimal under various conditions are stored in the table 18. For example, in order to attain an appropriate monitor output of 1.0 mA that means a desired light output at a temperature of 25 degrees centigrade, a pulse current of 10.0 mA and a bias current of 15.0 mA are recommended. The CPU 14 controls the LD driver 12 and thus the laser diode LD in accordance with the data of the table 18.

By examining characteristics of any individual laser diode LD and pre-storing appropriate data into the table 18, it is possible to control that individual diode appropriately.

As a writing approach, a serial interface 24 may be utilized. This allows for external writing of an appropriate drive current value into the table 18, reading of information from the central processing unit 14, and rewriting of a control program itself, via a connection having a small number of pins. Typical serial interfaces that may be used include SCSI, SPI, or I2C. By use of this interface, rewriting of a control program itself and reading of information from the CPU 14 can also be implemented.

Mechanisms for controlling the laser diode LD include a feed-forward control scheme and a feedback control scheme.

The feed-forward control scheme is such that based on the temperature table 18 as shown in Fig. 3, a predetermined current is conducted in response to a certain temperature. If the temperature can be detected, a required drive current can be obtained from the memory. In this way, temperature characteristics that are difficult to represent by way of a mathematical function can be readily stored on a basis of specific laser diodes. As shown in Fig. 4, it is desirable to increase both the bias current and pulse current as the temperature rises.

The feedback control scheme is such that when the light-emission efficiency of a laser diode degrades due to aging, such degradation is compensated for. The photo diode PD receives light from the laser diode LD and conducts a monitor current, Im, in relation to the intensity of the light. The CPU 14 controls the laser diode LD so that a target current value is observed as the feedback current monitor 20 monitors the monitor current Im. Aging of the monitor diode itself is insignificant.

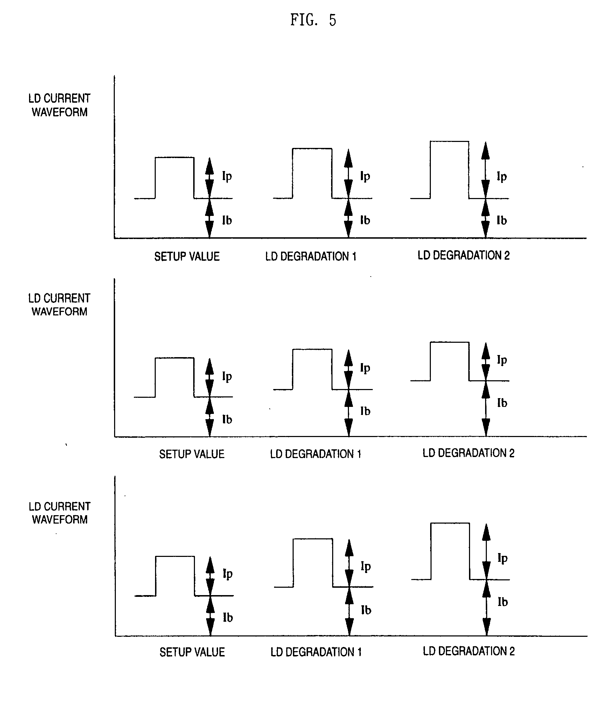

For diodes with different degradation characteristics, three types of control schemes are available, for example, as shown in Fig. 5, which can implement different control accordingly. As the laser diode degrades, the first scheme is to increase only the pulse current value; the second scheme is to increase only the bias current value; and the third scheme is to increase both the bias current value and pulse current value while keeping constant the Ip/Ib ratio. The Ip/Ib ratio may be computed at the CPU 14 or a predetermined ratio value may be stored in the table 18.

The embodiment of the present invention is so configured that a laser diode of any light-emission characteristics (including non-linear characteristics) can be controlled, as well as laser diodes with any aging characteristics. Thus, a wide range of laser diodes can be flexibly utilized, thereby reducing their manufacturing cost and enhancing reliability of their light-emission output.

## Claims

1. A laser diode control apparatus for controlling the light-emission output of a laser diode in accordance with temperature data, comprising:
a driver circuit (12), connected to said laser diode, for supplying a drive current to said laser diode;
a digital storage means (18) for pre-storing respective drive current values appropriate under a plurality of temperature conditions for individual laser diodes; and
a central processing unit, coupled to said digital storage means, for controlling, via the driver circuit, said laser diode in accordance with the temperature data and the appropriate drive current value from said digital storage means.

2. A laser diode control apparatus according to claim 1, further comprising:
a serial interface (24) connected to said central processing unit;
wherein at least one of writing of an appropriate drive current value into said digital storage means, reading of information from said central processing unit, and rewriting of a control program itself can be performed externally via said serial interface.

3. A laser diode control apparatus according to claim 1, wherein:
said central processing unit controls a bias current value and a pulse current value, thereby controlling said laser diode.

4. A laser diode control apparatus according to claim 1, wherein:
the temperature data is supplied by an on-chip temperature sensor integrated with said control apparatus.

5. A laser diode control apparatus for controlling the light-emission output of a laser diode in accordance with temperature data, comprising:
a driver circuit (12), connected to said laser diode, for supplying a drive current to said laser diode;
a monitoring means (PD), connected to said laser diode, for monitoring the light emitted by said laser diode and generating a monitor output;
a digital storage means (18) for pre-storing an appropriate drive current change under degraded condition of the laser diode; and
a central processing unit, coupled to said digital storage means and said monitoring means, for controlling said laser diode via the driver circuit so that said monitor output approaches a target value, in accordance with the monitor output and the appropriate drive current change from said digital storage means.

6. A laser diode control apparatus according to claim 5, further comprising:
a serial interface (24) connected to said central processing unit;
wherein at least one of writing of an appropriate drive current value into said digital storage means, reading of information from said central processing unit, and rewriting of a control program itself can be performed externally via said serial interface.

7. A laser diode control apparatus according to claim 5, wherein:
said central processing unit varies a bias current value or a pulse current value, thereby controlling said laser diode.
